# EUROPÄISCHE PATENTSCHRIFT

(11) **EP 4 127 631 B1**
(45) Veröffentlichungstag und Bekanntmachung des Hinweises auf die Patenterteilung: **07.05.2025**
(21) Anmeldenummer: 21713935.1
(22) Anmeldetag: 19.03.2021
(51) Int. Cl.: H01R 13/04, G01K 1/14, B60L 53/16, G01K 1/16, H01R 13/66

(54) **ELEKTROANSCHLUSSEINRICHTUNG UND VERFAHREN ZUR MONTAGE EINER ELEKTROANSCHLUSSEINRICHTUNG**
ELECTRICAL CONNECTION DEVICE AND METHOD FOR MOUNTING AN ELECTRICAL CONNECTION DEVICE
DISPOSITIF DE CONNEXION ÉLECTRIQUE ET PROCÉDÉ DE MONTAGE D'UN DISPOSITIF DE CONNEXION ÉLECTRIQUE

(30) Priorität: 27.03.2020 DE 102020108507
(43) Veröffentlichungstag der Anmeldung: 08.02.2023
(73) Patentinhaber: ALCA ELEKTRIK - MECHANIK - VERTRIEB GMBH, 57399 Kirchhundem (DE)
(72) Erfinder: HILLE, Jan, 57462 Olpe (DE); ENGELBRECHT, Timo, 57223 Kreuztal (DE)
(74) Vertreter: RavensPAT Patentanwälte Partnerschaft mbB
(86) Internationale Anmeldenummer: PCT/EP2021/057044
(87) Internationale Veröffentlichungsnummer: WO 2021/191061

(56) Entgegenhaltungen:
- EP-A1- 3 528 349
- EP-B1- 3 528 349
- DE-A1- 102015 106 251
- DE-A1- 102018 120 057

## Beschreibung

Die Erfindung betrifft eine Elektroanschlusseinrichtung gemäß dem Oberbegriff des Anspruchs 1 sowie ein Verfahren zur Montage einer Elektroanschlusseinrichtung gemäß dem Anspruch 16.

Aus der DE 10 2016 211 876 A1 ist ein als Elektroanschlusseinrichtung ausgeführter Ladestecker bekannt, welcher wenigstens einen Kontakt, wenigstens einen Temperatursensor und wenigstens eine Leiterplatte umfasst, wobei der Kontakt durch eine Ausnehmung der Leiterplatte geführt ist und wobei der Temperatursensor auf der Leiterplatte in der Nähe des Kontakts angeordnet ist.

Weiterhin ist aus dem Dokument DE 10 2015 106251 A1 ein Steckverbinderteil zum Verbinden mit einem Gegensteckverbinderteil umfasst ein Gehäuseteil, mindestens ein an dem Gehäuseteil angeordnetes, elektrisches Kontaktelement zum Herstellen eines elektrischen Kontakts mit dem Gegensteckverbinderteil und eine Temperaturüberwachungseinrichtung mit mindestens einer Sensoreinrichtung zum Detektieren einer Erwärmung an dem mindestens einen Kontaktelement. Dabei ist vorgesehen, dass die Temperaturüberwachungseinrichtung ein flächig entlang einer Ebene erstrecktes Trägerelement mit mindestens einer Öffnung und einer an der mindestens einen Öffnung angeordneten Kontaktfläche aufweist, wobei das mindestens eine Kontaktelement sich derart durch die mindestens eine Öffnung hindurch erstreckt, dass das mindestens eine Kontaktelement mit der Kontaktfläche in Anlage ist, und die mindestens eine Sensoreinrichtung an dem Trägerelement zur Detektion einer Erwärmung an dem mindestens einen Kontaktelement angeordnet ist. Auf diese Weise wird ein Steckverbinderteil bereitgestellt, das auf einfache und kostengünstige Weise eine Temperaturüberwachung mit schnellem Ansprechverhalten und einfachem Aufbau ermöglicht.

Weiterhin ist aus dem Dokument DE 10 2018 120057 A1 eine Temperaturmesseinrichtung für Steckverbinder bekannt, beinhaltend mindestens ein Trägerelement, mindestens ein Temperaturmessmittel samt Leiterbahnen sowie bedarfsweise mindestens ein aus Keramikmaterial bestehendes Deckelement, wobei das Temperaturmessmittel samt Leiterbahnen auf dem Trägerelement oder zwischen dem Trägerelement und dem bedarfsweisen Deckelement aufgebracht und zumindest mit einem der beiden Bauteile in Wirkverbindung steht, dergestalt, dass die Verbindung der Bauteile durch ein Glaslot erfolgt.

Weiterhin ist aus dem Dokument EP 3 528 349 A1 Ein elektrischer Stecker für ein Netzkabel, umfassend ein Steckergehäuse mit mindestens einem länglichen elektrischen Stromanschluss, der in einem Hohlraum des Steckergehäuses angeordnet ist, mindestens einen Temperatursensor und mindestens ein längliches Wärmeübertragungselement, wobei das Wärmeübertragungselement erste Kopplungsmittel zum mechanischen und thermischen Verbinden des elektrischen Leistungsanschlusses mit dem länglichen Wärmeübertragungselement auf einer ersten Seite umfasst Ende und wobei das längliche Wärmeübertragungselement zweite Kopplungsmittel zum mechanischen und thermischen Verbinden des Thermosensors mit dem länglichen Wärmeübertragungselement an einem zweiten Ende umfasst.

Der Erfindung liegt die Aufgabe zugrunde, eine Elektroanschlusseinrichtung bzw. ein Verfahren zur Montage einer Elektroanschlusseinrichtung zu entwickeln, welche bzw. welches kostengünstig und einfach herstellbar bzw. ausführbar ist, mittels welcher sich eine aktuelle Temperatur des wenigstens einen Kontakts besonders zuverlässig überwachen lässt und mittels welchem eine zuverlässige Anbindung eines Kontakts an eine Temperaturüberwachung herstellbar ist.

Diese Aufgabe wird von den Merkmalen des Anspruchs 1 bzw. 16 gelöst. In den Unteransprüchen 2 bis 15 sind vorteilhafte und zweckmäßige Weiterbildungen zum Anspruch 1 angegeben.

Die erfindungsgemäße Elektroanschlusseinrichtung umfasst wenigstens einen Kontakt und einen Träger, sowie eine Tragplatte,
- wobei der Träger wenigstens eine Aufnahme umfasst und der Kontakt in diese Aufnahme eingesteckt ist,
- wobei der Träger eine Leiterplatte und wenigstens einen Temperatursensor umfasst,
- wobei der Temperatursensor auf der Leiterplatte in der Nähe des Kontakts angeordnet ist,
- wobei die Leiterplatte eine elektrisch isolierende Schicht und eine von der Tragplatte durch die elektrisch isolierende Schicht getrennte, elektrisch leitende Oberschicht umfasst,
- wobei die elektrisch leitende Oberschicht im Bereich einer Ausnehmung der elektrisch isolierende Schicht angeordnet ist und einen äußeren Anschlussbereich und einen inneren Kontaktbereich umfasst,
- wobei der innere Kontaktbereich durch den Kontakt derart durch eine Ausnehmung der Tragplatte hindurch umgeformt ist, dass die elektrisch leitende Oberschicht an einer Mantelfläche des Kontakts anliegt,
- wobei eine Oberseite der Tragplatte angrenzend zu deren Ausnehmung hin als primäre Biegekante ausgebildet ist, über welche die elektrisch leitende Oberschicht der Leiterplatte um 5° bis 90° umgebogen ist.

Durch ein einfaches Anlegen der elektrisch leitenden Oberschicht an die Mantelfläche ist die Elektroanschlusseinrichtung einfach herstellbar.

Weiterhin ist es vorgesehen, die elektrisch leitende Oberschicht um die Ausnehmung der elektrisch isolierenden Schicht herum mit dieser zu verbinden. Hierdurch ist einem Verrutschen der elektrisch leitenden Oberschicht wirksam vorgebeugt.

Es ist auch vorgesehen, die Tragplatte starr auszubilden und die Leiterplatte im Vergleich zu der Tragplatte flexibel auszubilden. Hierdurch erhält die flexible Leiterplatte durch die Tragplatte Stabilität.

Es ist weiterhin vorgesehen, dass die Leiterplatte als dritte Schicht eine elektrisch leitende Unterschicht umfasst, wobei die elektrisch leitende Unterschicht von der elektrisch leitenden Oberschicht durch die elektrisch isolierende Schicht galvanisch getrennt ist, wobei der Temperatursensor auf der elektrisch leitenden Unterschicht angeordnet ist und an durch die elektrisch leitende Unterschicht ausgebildete Kontaktstellen angeschlossen ist, wobei der Temperatursensor derart positioniert ist, dass dieser einem Segment der elektrisch leitenden Oberschicht gegenüberliegt, wobei die isolierende Schicht insbesondere aus Polyimid hergestellt ist. Durch einen derartigen Aufbau lässt sich die Temperatur der einzelnen Kontakte zuverlässig überwachen, da die temperaturleitenden Bauteile nur eine geringe Wärmekapazität aufweisen und zur elektrischen Isolierung nur minimal voneinander beabstandet sind. Somit können Temperaturänderungen der einzelnen Kontakte jeweils mit geringer Verzögerung von dem Temperatursensor erkannt werden. Durch eine Verwendung von Polyimid für die isolierende Schicht weist diese wärmeleitende Eigenschaften auf, so dass die elektrischen leitende Oberschicht und die elektrisch leitende Unterschicht thermisch miteinander gekoppelt sind. Die elektrischen leitende Oberschicht und die elektrisch leitende Unterschicht sind als Kupferschichten wärmespeichernd ausgeführt, weisen aber relativ zur Wärmequelle, welche durch die Kontakte gebildet ist, eine geringe Trägheit in Bezug auf eine Temperaturänderung auf.

Weiterhin ist es vorgesehen, in der Tragplatte wenigstens eine Aussparung vorzusehen, wobei die Aussparung zu der Oberseite der Tragplatte, welche der Leiterplatte zugewandt ist, geöffnet ist und wobei die Aussparung derart positioniert und dimensioniert ist, dass der Temperatursensor in der Aussparung aufgenommen ist. Hierdurch ist der Temperatursensor mechanisch geschützt und auch gegenüber dem bzw. den Kontakten elektrisch isoliert, so dass ein störungsfreier Betrieb gesichert ist.

Es ist auch vorgesehen,
- die Kontaktstellen, mit welchen der Temperatursensor verbunden ist, an Leitungen anzuschließen,
- die Leitungen in Form von Leiterbahnen durch die elektrisch leitende Unterschicht zu bilden, wobei diese zu dem Temperatursensor hin einen mäanderartigen Verlauf aufweisen und
- wobei es insbesondere vorgesehen ist, dass die Elektroanschlusseinrichtung eine Regeleinrichtung umfasst und dass der wenigstens eine Temperatursensor über die Leitungen an die Regeleinrichtung angeschlossen ist
- wobei es insbesondere auch vorgesehen ist, dass die Leiterplatte einen Polyimidfilm umfasst, welcher die Leiterbahnen überdeckt.

Durch den mäanderartigen Verlauf der Leiterbahnen wird eine ungewünschte Ableitung von Wärme reduziert und somit einer Verfälschung der Messergebnisse vorgebeugt. Durch den Polyimidfilm sind die Leiterbahnen zusätzlich elektrisch isoliert und geschützt.

Weiterhin ist es vorgesehen, die Elektroanschlusseinrichtung mit einer auf der Leiterplatte aufliegende obere Deckplatte auszustatten und/oder die Elektroanschlusseinrichtung mit einer auf der Tragplatte aufliegende untere Deckplatte auszustatten. Durch die Deckplatten erfolgt eine weitere Stabilisierung der Tragplatte, so dass diese den wenigstens einen Kontaktstift zuverlässig halten kann. Weiterhin erfolgt durch die untere Deckplatte eine optimierte Anlage der leitenden Oberschicht an den bzw. die Kontakte.

Es ist auch vorgesehen, eine Oberseite der Tragplatte angrenzend zu deren Ausnehmung hin als primäre Biegekante auszubilden, über welche die elektrisch leitende Oberschicht der Leiterplatte um wenigstens 15° umgebogen ist. Hierdurch wird die Tragplatte selbst zu einem Montagewerkzeug, so dass die Herstellung der Elektroanschlusseinrichtung vereinfacht ist.

Weiterhin ist es auch vorgesehen, die Elektroanschlusseinrichtung mit einer oberen Deckplatte auszustatten, wobei die obere Deckplatte eine auf die Ausnehmungen der Leiterplatte ausgerichtet obere Durchgangsbohrung umfasst und wobei die obere Deckplatte eine Oberseite der Leiterplatte abdeckt und/oder die Elektroanschlusseinrichtung mit einer unteren Deckplatte auszustatten, wobei die untere Deckplatte eine auf die Ausnehmungen der Leiterplatte ausgerichtet untere Durchgangsbohrung umfasst und wobei die untere Deckplatte eine Unterseite der Tragplatte abdeckt. Hierdurch ist bei jeder der drei Bauformen ein stabilisierter Träger gebildet, welcher den bzw. die Kontakte zuverlässig halten kann.

Weiterhin ist es vorgesehen, dass eine umlaufende Kante der unteren Deckplatte, an welcher eine Oberseite der unteren Deckplatte in eine untere Durchgangsbohrung übergeht, eine sekundäre Biegekante bildet, durch welche die elektrisch leitende Oberschicht der Leiterplatte an die Mantelfläche des Kontakts derart angeformt ist, dass die elektrisch leitende Oberschicht zwischen einer Innenmantelfläche der unteren Durchgangsbohrung und der Mantelfläche des Kontakts eingeklemmt ist. Hierdurch wird die untere Deckplatte selbst zu einem weiteren Montagewerkzeug, so dass die Herstellung der Elektroanschlusseinrichtung vereinfacht ist und ein zuverlässiger Kontakt zu der elektrisch leitenden Oberschicht hergestellt ist.

Es ist auch vorgesehen, die Elektronanschlusseinrichtung mit den zwei Kontakten und dem Träger auszustatten, wobei der Träger die Tragplatte und die Leiterplatte und insbesondere die obere Deckplatte und insbesondere die untere Deckplatte umfasst, wobei diese Platten miteinander verbunden sind und jeweils einen zwischen den Kontakten angeordneten Schlitz umfassen, wobei die Kontakte spiegelbildlich zu den Schlitzen angeordnet sind. Hierdurch ist eine elektrische und thermische Isolierung der Kontakte erreicht, so dass das Messergebnis durch den jeweils anderen Kontakt weniger beeinflusst werden kann. Die bessere elektrische Isolierung ist insbesondere durch eine Vergrößerung der Kriechstrecke erreicht.

Weiterhin ist es auch vorgesehen, die Ausnehmung in der Tragplatte als polygonförmige Ausnehmung auszubilden und die untere Durchgangsbohrung in der unteren Deckplatte kreisförmig auszubilden, wobei es insbesondere vorgesehen ist, dass die untere Durchgangsbohrung in einer Projektion in Richtung einer Längsachse des Kontakts einen Inkreis der polygonförmigen Ausnehmung bildet. Hierdurch nimmt der Träger bei der Montage beim Einschieben des bzw. der Kontakte in dessen Aufnahmen einen mit fortschreitendem Einschubweg zunehmend stärkeren Einfluss auf eine Umformung der elektrisch leitenden Oberschicht der Leiterplatte, so dass eine abrupte und die elektrisch leitende Oberschicht ggf. verletzende Umformung vermieden ist.

Es ist auch vorgesehen, dass der äußere Anschlussbereich des Leiterbereichs der elektrisch leitenden Oberschicht die Ausnehmung der Leiterplatte ringartig umgibt und dass der innere Kontaktbereich der elektrisch leitenden Oberschicht durch von dem äußeren Anschlussbereich ausgehende Kontaktfahnen gebildet ist, wobei es insbesondere vorgesehen ist, dass die Zahl der Kontaktfahnen der Zahl der Ecken der polygonförmige Ausnehmung der Tragplatte entspricht. Hierdurch ist die Umformung der elektrisch leitenden Oberschicht, welche als Bestandteil der Leiterplatte die Kontaktfahnen ausbildet, weiter erleichtert und somit eine fehlerfreie Herstellung der Elektroanschlusseinrichtung gewährleistet.

Weiterhin ist es vorgesehen, den Kontakt mit einem über seine Mantelfläche vorspringenden, umlaufenden Kragen auszustatten und mit einer kreisringförmigen Unterseite seines Kragens auf dem äußeren Anschlussbereich der elektrisch leitenden Oberschicht der Leiterplatte zur Anlage zu bringen. Hierdurch wird eine Kontaktfläche zwischen dem Kontakt und der elektrisch leitenden Oberschicht weiter vergrößert, so dass ein Abgriff der aktuellen Temperatur des Kontakts schneller und zuverlässiger erfolgen kann.

Schließlich ist es vorgesehen, die Elektroanschlusseinrichtung als Ladestecker auszubilden und den wenigstens einen Kontakt jeweils als Kontaktstift auszubilden oder die Elektroanschlusseinrichtung als Ladebuchse auszubilden ist und den wenigstens einen Kontakt jeweils als Kontakthülse auszubilden. Hierdurch lässt sich die Herstellung vereinfachen, da der Träger der Elektroanschlusseinrichtung sowohl zur Herstellung eines Ladesteckers als auch zur Herstellung eine Ladebuchse verwendet werden kann.

Das erfindungsgemäße Verfahren zur Montage einer Elektroanschlusseinrichtung insbesondere entsprechend wenigstens einem der Ansprüche 1 bis 15 sieht vor,
- dass die Elektroanschlusseinrichtung einen Träger mit wenigstens einer Aufnahme und wenigstens einem Kontakt umfasst,
- wobei der Träger, in eine Einschubrichtung des Kontakts betrachtet, eine Leiterplatte mit einer elektrisch leitenden Oberschicht, eine insbesondere polygonförmig umlaufende primäre Biegekante und eine insbesondere kreisförmig umlaufende sekundäre Biegekante umfasst,
- wobei die elektrisch leitende Oberschicht insbesondere mit Kontaktfahnen in die Aufnahme ragt, und umfasst die Schritte:
- Einschieben des Kontakts bis von dem Kontakt die in die Aufnahme ragende elektrisch leitende Oberschicht berührt wird,
- weiteres Einschieben des Kontakts in die Aufnahme und hierbei Umbiegen der elektrisch leitenden Oberschicht und insbesondere auch der elektrisch isolierenden Schicht durch den Kontakt an der primären Biegekante und
- noch weiteres Einschieben des Kontakts in die Aufnahme und hierbei Umbiegen der elektrisch leitenden Oberschicht und insbesondere auch der elektrisch isolierenden Schicht durch den Kontakt an der sekundären Biegekante und Anlagen der Kontaktfahnen an eine Mantelfläche des Kontakts derart, dass die elektrische leitende Oberschicht in einem der sekundären Biegekante folgenden Bereich vollflächig an der Mantelfläche des Kontakts angelegt wird.

Diese Verfahren ermöglicht eine kostengünstige und einfache Herstellung einer Elektroanschlusseinrichtung, da eine zuverlässige Kontaktierung zwischen dem bzw. den Kontakten und der elektrisch leitenden Oberschicht beim Einschieben des bzw. der Kontakte in die Aufnahme bzw. Aufnahmen des Trägers erfolgt. Durch eine derartige werkzeugfreie Montage ist eine optimale Anbindung der elektrisch leitenden Oberschicht an den bzw. die Kontakte zuverlässig hergestellt, so dass sich eine aktuelle Temperatur des wenigstens einen Kontakts besonders zuverlässig überwachen lässt.

Im Sinne der Erfindung wird unter einem Temperatursensor insbesondere ein Thermowiderstand oder ein Halbleiter oder ein integrierter Schaltkreis oder ein Wärmestrahlungssensor verstanden.

Weitere Einzelheiten der Erfindung werden in der Zeichnung anhand von schematisch dargestellten Ausführungsbeispielen beschrieben.

Hierbei zeigt:
- Figur 1:: eine erfindungsgemäße Elektroanschlusseinrichtung in perspektivischer Ansicht, wobei ein zweiter Kontakt ausgeblendet ist;
- Figur 2:: eine Explosionsansicht der Darstellung der Figur 1, wobei eine Regeleinrichtung ausgeblendet ist;
- Figur 3:: eine perspektivische Ansicht einzelner Komponenten der in den Figuren 1 und 2 gezeigten Elektroanschlusseinrichtung;
- Figur 4:: einen Ausschnitt der in der Figur 2 gezeigten Explosionsansicht aus einer entgegen gesetzten Blickrichtung und
- Figur 5:: eine Draufsicht auf die Tragplatte und die unter der Tragplatte angeordnete untere Deckplatte.

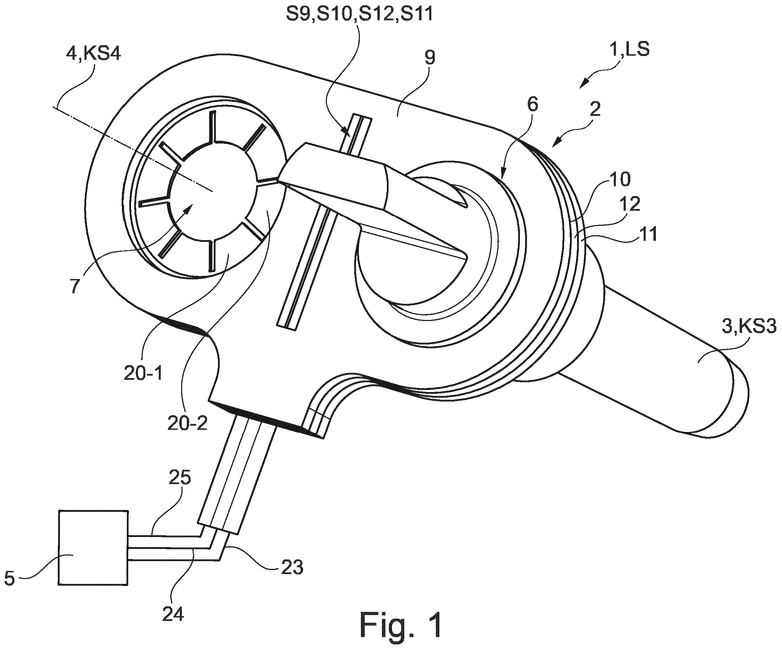

In der Figur 1 ist eine erfindungsgemäße Elektroanschlusseinrichtung 1 in perspektivischer Ansicht gezeigt. Die Elektroanschlusseinrichtung 1 umfasst einen Träger 2, einen ersten Kontakt 3, einen nur symbolisch durch eine Linie dargestellten zweiten Kontakt 4 und eine symbolisch dargestellte Regeleinrichtung 5. Der zweite Kontakt 4 ist baugleich zu dem ersten Kontakt 3 ausgeführt. Der Kontakt 3 ist in einer ersten Aufnahme 6 des Trägers 2 aufgenommen. Der zweite Kontakt 4 ist in einer zweiten Aufnahme 7 des Trägers 2 aufgenommen. Weiterhin umfasst der Träger 2 einen Schlitz S9-S10.

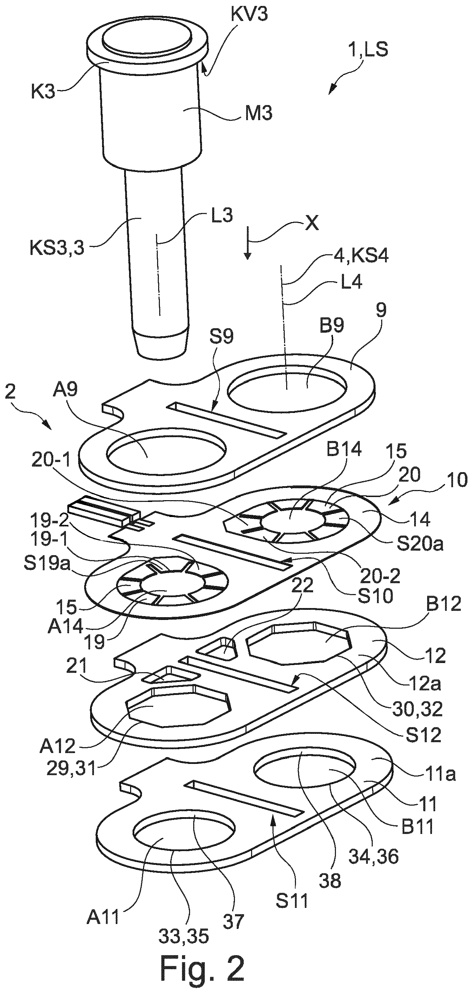

In der Figur 2 ist die Elektroanschlusseinrichtung 1 in Explosionsansicht dargestellt, wobei die Regeleinrichtung 5 ausgeblendet ist.

Der Träger 2 umfasst eine obere Deckplatte 9, eine flexible Leiterplatte 10, eine Tragplatte 12 und eine untere Deckplatte 11 (siehe auch Figur 1).

Die flexible Leiterplatte 10 umfasst als Mittelschicht eine elektrisch isolierende Schicht 14. Weiterhin umfasst die Leiterplatte 10 eine auf der elektrisch isolierende Schicht 14 angeordnete elektrisch leitende Oberschicht 15.

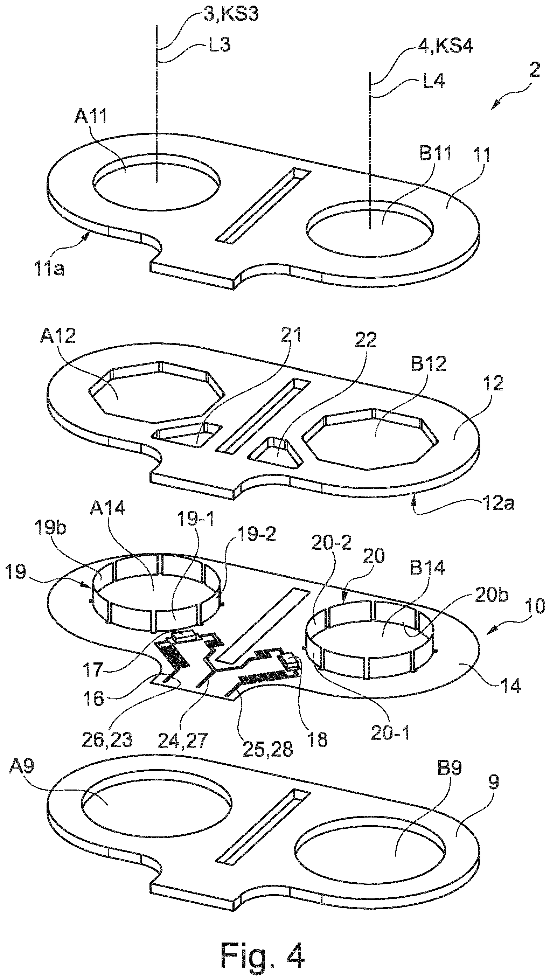

Wie aus der Figur 4 hervorgeht, welche einen Ausschnitt der in der Figur 2 gezeigten Explosionsansicht aus einer entgegen gesetzten Blickrichtung zeigt, umfasst die Leiterplatte 10, welche in der Figur 4 von unten gezeigt ist, als dritte Schicht eine elektrisch leitende Unterschicht 16.

Die elektrisch leitende Unterschicht 16 ist von der elektrisch leitenden Oberschicht 15 durch die elektrisch isolierende Schicht 14 galvanisch getrennt.

Der Träger 2 umfasst weiterhin auch zwei Temperatursensoren 17, 18. Diese sind auf der elektrisch leitenden Unterschicht 16 der Leiterplatte 10 jeweils in der Nähe des ersten Kontakts 3 bzw. des zweiten Kontakts 4 angeordnet.

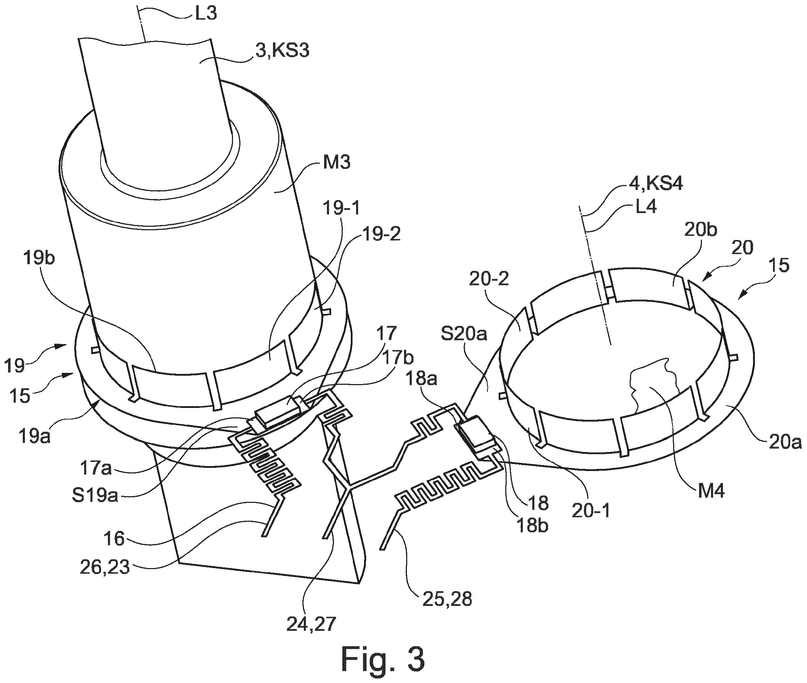

Wie aus der Figur 3 hervorgeht, welche eine perspektivische Ansicht einzelner Komponenten der in den Figuren 1 und 2 gezeigten Elektroanschlusseinrichtung 1 zeigt, sind die Temperatursensoren 17, 18 an durch die elektrisch leitende Unterschicht 16 ausgebildete Kontaktstellen 17a, 17b und 18a, 18b angeschlossen ist. Hierbei ist in der Figur 3 die elektrisch isolierende Schicht 14 ausgeblendet.

Die elektrisch leitende Oberschicht 15 ist zweiteilig ausgeführt und umfasst einen dem ersten Kontakt 3 zugeordneten ersten Leiterbereich 19 und einen dem zweiten Kontakt 4 zugeordneten zweiten Leiterbereich 20.

Der erste Leiterbereich 19 ist im Bereich einer ersten Ausnehmung A14 der elektrisch isolierende Schicht 14 angeordnet und umfasst einen äußeren Anschlussbereich 19a und einen inneren Kontaktbereich 19b. Hierbei ist der innere Kontaktbereich 19b durch den ersten Kontakt 3 derart durch eine erste Ausnehmung A12 der Tragplatte 12 hindurch umgeformt, dass die elektrisch leitende Oberschicht 15 mit ihrem Kontaktbereich 19b an einer Mantelfläche M3 des ersten Kontakts 3 anliegt.

Der zweite Leiterbereich 20 ist im Bereich einer zweiten Ausnehmung B14 der elektrisch isolierende Schicht 14 angeordnet und umfasst einen äußeren Anschlussbereich 20a und einen inneren Kontaktbereich 20b. Hierbei ist der innere Kontaktbereich 20b durch den zweiten Kontakt 4 derart durch eine zweite Ausnehmung B12 der Tragplatte 12 hindurch umgeformt, dass die elektrisch leitende Oberschicht 15 mit Ihrem Kontaktbereich 20b an einer in der Figur 3 ausschnittsweise angedeuteten Mantelfläche M4 des zweiten Kontakts 4 anliegt.

Der erste Temperatursensor 17 ist derart positioniert, dass dieser einem Segment S19a des äußeren Anschlussbereiche 19a des ersten Leiterbereichs 19 der elektrisch leitenden Oberschicht 15 gegenüberliegt. Hierdurch ist der Temperatursensor 17 nur durch die elektrisch isolierende Schicht 14 von dem ersten Leiterbereich 19 der elektrisch leitenden Oberschicht 15 getrennt, so dass die von dem ersten Leiterbereich 19 von dem ersten Kontakt 3 aufgenommene Wärmeenergie nur durch einen dünnen Polyimidfilm geleitet werden muss, durch welchen die elektrisch isolierende Schicht 14 gebildet ist. Somit sind das Segment S19a des ersten Leiterbereichs 19 und der auf der elektrisch leitenden Unterschicht 16 angeordnete erste Temperatursensor 17 derart zueinander angeordnet, dass ein Wärmestrom die elektrisch isolierende Schicht 14 orthogonal durchströmt um den ersten Temperatursensor 17 zu erreichen. Der zweite Temperatursensor 18 ist in vergleichbarer Weise angeordnet.

Hierbei ist der zweite Temperatursensor 18 derart positioniert, dass dieser einem Segment S20a des äußeren Anschlussbereiche 20a des zweiten Leiterbereichs 20 der elektrisch leitenden Oberschicht 15 gegenüberliegt. Hierdurch ist der Temperatursensor 18 nur durch die elektrisch isolierende Schicht 14 von dem zweiten Leiterbereich 20 der elektrisch leitenden Oberschicht 15 getrennt, so dass die von dem zweiten Leiterbereich 20 von dem zweiten Kontakt 4 aufgenommene Temperatur nur durch den erwähnten Polyimidfilm geleitet werden muss, durch welchen die elektrisch isolierende Schicht 14 gebildet ist.

Die elektrisch leitende Oberschicht 15 ist um die Ausnehmung A14 bzw. B14 der elektrisch isolierenden Schicht 14 herum mit dieser verbunden und insbesondere als auf die elektrisch isolierende Schicht 14 aufgebrachte Kupferkaschierung ausgebildet. Im Bereich der Ausnehmung A14 bzw. B14 ist die elektrisch leitende Oberschicht 15 bei nicht eingesteckten Kontakten 3, 4 als frei in die Ausnehmung A14 bzw. B14 hineinragende Fortsetzung der Kupferkaschierung ausgebildet. Es ist auch vorgesehen, dass die elektrisch isolierende Schicht 14, welche als Polyimidfilm ausgebildet ist, als Stütze für elektrisch leitenden Oberschicht 15 in die Ausnehmung A14 bzw. B14 hineinragt.

Der innere Kontaktbereich 19b des ersten Leiterbereichs 19 der elektrisch leitenden Oberschicht 15 ist als zu dem äußeren Anschlussbereich 19a des ersten Leiterbereichs 19 hin mehrfach in Bezug auf eine Längsachse L3 des ersten Kontakts 3 radial nach außen geschlitzter Kreisring ausgebildet, welcher eine Vielzahl von mit dem äußeren Anschlussbereich 19a verbundene, nur exemplarisch bezeichnete, Kontaktfahnen 19-1, 19-2 aufweist (siehe Figuren 1, 2, 3 und 4).

Der innere Kontaktbereich 20b des zweiten Leiterbereichs 20 der elektrisch leitenden Oberschicht 15 ist als zu dem äußeren Anschlussbereich 20a des zweiten Leiterbereichs 20 hin mehrfach in Bezug auf eine Längsachse L4 des zweiten Kontakts 4 radial nach außen geschlitzter Kreisring ausgebildet, welcher eine Vielzahl von mit dem äußeren Anschlussbereich 20a verbundene, nur exemplarisch bezeichnete, Kontaktfahnen 20-1, 20-2 aufweist (siehe Figuren 1, 2, 3 und 4).

Die Tragplatte 12 ist starr ausgebildet und die Leiterplatte 10 ist im Vergleich zu der Tragplatte 12 flexibel ausgebildet. Die Leiterplatte 10 ist dreischichtig ausgeführt, wobei die elektrisch leitende Oberschicht 15 als Kupferkaschierung ausgebildet ist, wobei die elektrisch isolierende Schicht 14 als Polyimidfilm ausgebildet ist und wobei die elektrisch leitende Unterschicht 16 als weitere Kupferkaschierung ausgebildet ist. Entsprechend ist die Leiterplatte durch eine dreischichtige Folie gebildet. Es ist auch vorgesehen, dass die Oberschicht 15 und die Unterschicht 16 in Bereichen, in welchen diese nicht kontaktiert sind jeweils durch einen nicht dargestellten Polyimidfilm zur elektrischen Isolation überzogen sind.

Wie es aus den Figuren 2 und 4 ersichtlich ist, umfasst die Tragplatte 12 zwei Aussparungen 21, 22, die zu einer der Leiterplatte 10 zugewandten Oberseite 12a der Tragplatte 12 geöffnet sind. Die Aussparungen 21, 22 sind derart positioniert und dimensioniert, dass der erste Temperatursensor 17 in der ersten Aussparung 21 aufgenommen ist und dass der zweite Temperatursensor 18 in der zweite Aussparung 22 aufgenommen ist. Die Aussparungen 21, 22 bilden jeweils eine Kapselung für den ersten Temperatursensor 17 bzw. den zweiten Temperatursensor 18, durch welche diese gegenüber den Kontaktstiften auch elektrisch isoliert sind.

Die Kontaktstellen 17a, 17b bzw. 18a, 18b, mit welchen der erste bzw. der zweite Temperatursensor 17, 18 verbunden sind, sind an drei Leitungen 23, 24, 25 angeschlossen. Diese Leitungen 23, 24, 25 sind als Leiterbahnen 26, 27, 28 durch die elektrisch leitende Unterschicht 16 gebildet. Zu den Temperatursensoren 17, 18 hin weisen die Leiterbahnen 26, 27, 28 einen mäanderartigen Verlauf auf. Insbesondere diese Leiterbahnen 26, 27, 28 sind durch jeweils einen der oben erwähnten, nicht dargestellten Polyimidfilme überzogen. Wie oben bereits erwähnt ist in der Figur 3 die elektrisch isolierende Schicht 14 der Leiterplatte 10 ausgeblendet und es sind nur die elektrisch leitende Oberschicht 15, welche den ersten Leiterbereich 19 und den zweiten Leiterbereich 20 umfasst, gezeigt und die elektrisch leitende Unterschicht 16, welche die Kontaktstellen 17a, 17b, 18a, 18b und die Leiterbahnen 26, 27, 28 umfasst, gezeigt.

Die Temperatursensoren 17, 18 sind über die Leitungen 23, 24, 25 an die Regeleinrichtung 5 angeschlossen, so dass diese zum Beispiel bei einer drohenden Überschreitung einer kritischen Temperatur des ersten und/oder zweiten Kontaktes 3, 4 eine Reduzierung eines Ladestroms auslösen kann.

Wie es insbesondere aus den Figuren 1 und 2 ersichtlich ist, liegt die obere Deckplatte 9 auf der Leiterplatte 10 auf und liegt die untere Deckplatte 11 an der Tragplatte 12 an, so dass ein kompakter Aufbau des Trägers 2 gewährleistet ist. Hierbei sind die genannten Platten miteinander verklebt oder in anderer Weise verbunden.

Die Oberseite 12a der Tragplatte 12 ist durch umlaufende Kanten 29, 30 angrenzend zu der ersten Ausnehmung A12 bzw. zu der zweiten Ausnehmung B12 hin als primäre Biegekante 31, 32 ausgebildet. Über diese Biegekanten 31, 32 der Tragplatte ist die elektrisch leitende Oberschicht 15 in Form des ersten Leiterbereichs 19 und des zweiten Leiterbreichs 20 im fertig montierten Zustand der Elektroanschlusseinrichtung 1 insbesondere um fast 90° durch den ersten Kontakt 3 bzw. den zweiten Kontakt 4 umgebogen. Hierbei erfolgt die Biegung in einem Übergangsbereich zwischen dem äußeren Anschlussbereich 19a bzw. 20a des der ersten Leiterbereichs 19 bzw. des zweiten Leiterbreichs 20 und dem inneren Kontaktbereich 19b bzw. 20b des der ersten Leiterbereichs 19 bzw. des zweiten Leiterbreichs 20 der elektrisch leitenden Oberschicht 15. In den Figuren 3 und 4 ist die elektrisch leitende Oberschicht 15 in diesem umgebogenen Zustand gezeigt, wobei die Kontakte in der Explosionsdarstellung der Figur 4 nur schematisch eingezeichnet sind. Sofern - wie oben ausgeführt - die Oberschicht 15 durch die elektrisch isolierende Schicht 14, welche als Polyimidfilm ausgebildet ist, im Bereich der Ausnehmung A14 bzw. B14 unterstützt ist, ist selbstverständlich auch die elektrisch isolierende Schicht 14 mit umgebogen, wobei diese in der Figur 3 nicht dargestellt ist. Aus der Figur 3 ist ersichtlich, wie der innere Kontaktbereich 19b an der Mantelfläche M3 des ersten Kontakts 3 anliegt und wie der innere Kontaktbereich 10b an der Mantelfläche M4 des zweiten Kontakts 4 anliegt.

Die obere Deckplatte 9 umfasst auf die Ausnehmungen A14, B14 der Leiterplatte 10 bzw. von deren elektrisch isolierender Schicht 14 ausgerichtet obere Durchgangsbohrung A9, B9. Die untere Deckplatte 11 umfasst auf die Ausnehmungen A14, B14 der Leiterplatte 10 bzw. von deren elektrisch isolierender Schicht 14 ausgerichtet untere Durchgangsbohrung A11, B11. Durch die genannten Ausnehmungen und Durchgangsbohrungen sind die Aufnahmen 6 und 7 des Trägers 2 gebildet.

An einer Oberseite 11a der unteren Deckplatte 11 um die Durchgangsbohrungen A11, B11 umlaufende Kanten 33, 34 bilden sekundäre Biegekanten 35, 36. Durch diese Biegekanten 35, 36 ist die elektrisch leitende Oberschicht 15 der Leiterplatte 10 in Form des ersten Leiterbereichs 19 und des zweite Leiterbereich 20 mit ihren inneren Kontaktbereichen 19b bzw. 20b derart an die Mantelflächen M3 bzw. M4 der Kontakte 3, 4 angeformt, dass die elektrisch leitende Schicht 15 zwischen Innenmantelflächen 37, 38 der unteren Durchgangsbohrungen A11, B11 und den Mantelflächen M3 bzw. M4 der Kontakte 3, 4 eingeklemmt und angedrückt ist.

Die beiden Kontakte 3, 4 der Elektronanschlusseinrichtung 1 sind in Bezug auf ihre Längsachsen L3, L4 parallel zueinander angeordnet. Zur besseren elektrischen Isolierung umfassen die Tragplatte 12 und die Leiterplatte 10 und die obere Deckplatte 9 und die untere Deckplatte 11 jeweils einen Schlitz S12, S10, S9, S11. Die Kontakte 3, 4 sind jeweils spiegelbildlich zu dem Schlitz S12, S10, S9, S11 angeordnet.

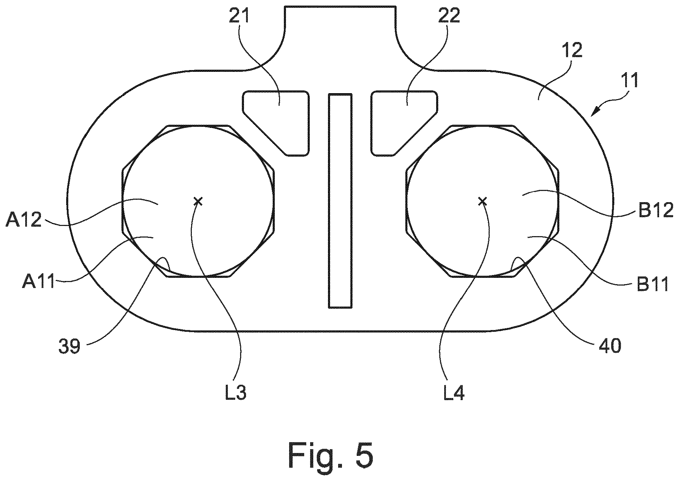

Insbesondere aus den Figuren 2, 4 und 5 ist es ersichtlich, dass die Ausnehmungen A12, B12 in der Tragplatte 12 als polygonförmige Ausnehmung ausgebildet sind und dass die Durchgangsbohrungen A11, B11 in der unteren Deckplatte 11 kreisförmig ausgebildet sind. In der Figur 5 ist die untere Deckplatte 11 unter der Tragplatte 12 angeordnet. Die Durchgangsbohrungen A11, B11 der unteren Deckplatte 11 bilden - in einer Projektion in Richtung der senkrecht in die Zeichnungsebene hinein verlaufenden Längsachsen L3, L4 der Kontakt 3, 4 betrachtet - jeweils einen Inkreis 39 bzw. 40 zu dem polygonförmigen Ausnehmung A12 bzw. B12 der Tragplatte 12. Entsprechend erfolgt beim Einschieben der Kontakte 3, 4 in die Aufnahmen 6, 7 des Träger 2 im Bereich der Tragplatte 12 zunächst ein Abknicken der Kontaktfahnen 19-1, 19-2 bzw. 20-1, 20-2 des ersten Leiterbereichs 19 bzw. des zweiten Leiterbereich 20 der elektrisch leitenden Oberschicht 15 und dann im Bereich der unteren Deckplatte 11 ein flächiges Anlegen Kontaktfahnen 19-1, 19-2 bzw. 20-1, 20-2 den ersten Kontakt 3 bzw. den zweiten Kontakt 4.

Die äußeren Anschlussbereiche 19a bzw. 20a der Leiterplatte 10 umgeben die Ausnehmung A14, B14 der Leiterplatte 10 ringartig und die inneren Kontaktbereich 19b bzw. 20b der Leiterplatte 10 sind durch die Kontaktfahnen 19-1, 19-2 bzw. 20-1, 20-2 gebildet, welche jeweils von den äußeren Anschlussbereichen 19a bzw. 20a ausgehen. Hierbei entspricht die Zahl der Kontaktfahnen 19-1, 19-2 bzw. 20-1, 20-2 jeweils der Zahl der Ecken der polygonförmigen Ausnehmung A12 bzw. B12 der Tragplatte 12.

Die Kontaktfahnen 19-1, 19-2 bzw. 20-1, 20-2, welche entsprechend den oben stehenden Ausführungen nicht nur aus Abschnitten der elektrisch leitfähigen Oberschicht 15, sondern alternativ auch aus Abschnitten der elektrisch leitfähigen Oberschicht 15 und aus Abschnitten der elektrisch isolierenden Schicht 14 bestehen können, sind jeweils als mit dem äußeren Anschlussbereich 19a bzw. 20a verbundene Laschen ausgebildet.

Die beiden Kontakte 3, 4 umfassen jeweils einen über ihre Mantelfläche M3 vorspringenden, umlaufenden Kragen K3. Mit einer kreisringförmigen Unterseite KU3 dieses Kragens K3 liegen die Kontakte 3, 4 jeweils auf dem äußeren Anschlussbereich 19a bzw. 20a der elektrisch leitenden Oberschicht 15 der Leiterplatte 10 an, so dass auch hier eine Wärmeübertragung von dem Kontakt 3 bzw. 4 auf den ersten Leiterbereich 19 bzw. den zweiten Leiterbereich 20 erfolgt. Außerhalb von Auflageflächen, mit welchen die Kontaktstifte KS3, KS4 auf der elektrisch leitenden Oberschicht 15 aufliegen, ist diese in ihrem äußeren Anschlussbereich 19a bzw. 20a durch nicht dargestellte, isolierende Schichten, welche z.B. durch die oben erwähnten Polyimidfilme gebildet sind, auch gegen eine Beschädigung und insbesondere gegen ein Ausreißen geschützt. Der Kontakt 4 ist in den Figuren nur schematisch dargestellt, weist aber eine zu dem Kontakt 3 vergleichbare Bauform auf. Hierbei werden die Kontakt 3, 4 bei der Montage in eine Einschubrichtung x (siehe Figur 2) in die Aufnahmen 6 bzw. 7 des Trägers 2 eingeschoben.

Die Durchgangsbohrungen A9 und B9 der oberen Deckplatte 9 sind derart dimensioniert, dass diese den Kragen K3 des Kontakts 3 bzw. 4 jeweils aufnehmen, so dass diese mit ihrem Kragen K3 jeweils auf der Leiterplatte 10 aufliegen.

Die in den Figuren 1 bis 5 gezeigte Elektroanschlusseinrichtung 1 ist als Ladestecker LS ausgebildet und ihre Kontakte 3, 4 sind jeweils als Kontaktstift KS3, KS4 ausgebildet.

Gemäß einer Ausführungsvariante ist es auch vorgesehen, eine Elektroanschlusseinrichtung als Ladebuchse auszubilden, wobei deren Kontakte als Kontakthülsen ausgebildet sind.

Ein Verfahren zur Montage der Elektroanschlusseinrichtung 1, welche insbesondere entsprechend wenigstens einem der Ansprüche 1 bis 15 ausgebildet ist, sieht vor,
- dass die Elektroanschlusseinrichtung 1 einen Träger 2 mit wenigstens einer Aufnahme 6, 7 und wenigstens einen Kontakt 3, 4 umfasst,
- dass der Träger 2 in eine Einschubrichtung x des Kontakts 3, 4 betrachtet eine Leiterplatte 10 mit einer elektrisch leitenden Oberschicht 15, eine insbesondere polygonförmig umlaufende primäre Biegekante 31, 32 und eine insbesondere kreisförmig umlaufende sekundäre Biegekante 35, 36 umfasst und
- dass die elektrisch leitende Oberschicht 15 insbesondere mit Kontaktfahnen 19-1, 19-2, 20-1, 20-2 in die Aufnahme 6, 7 ragt,
und sieht die Schritte vor:
- Einschieben des Kontakts 3, 4 bis von dem Kontakt 3, 4 die in die Aufnahme 6, 7 ragende elektrisch leitende Oberschicht 15 berührt wird,
- weiteres Einschieben des Kontakts 3, 4 in die Aufnahme 6, 7 und hierbei Umbiegen der elektrisch leitenden Oberschicht 15 und insbesondere auch der elektrisch isolierenden Schicht 14 durch den Kontakt 3, 4 an der primären Biegekante 31, 32 und
- noch weiteres Einschieben des Kontakts 3, 4 in die Aufnahme 6, 7 und hierbei Umbiegen der elektrisch leitenden Oberschicht 15 und insbesondere auch der elektrisch isolierenden Schicht 14 durch den Kontakt 3, 4 an der sekundäre Biegekante 35, 36 und Anlagen der Kontaktfahnen 19-1, 19-2, 20-1, 20-2 an eine Mantelfläche M3, M4 des Kontakts 3, 4 derart, dass die elektrische leitende Oberschicht 15 in einem der sekundären Biegekante 35, 36 folgenden Bereich vollflächig an der Mantelfläche M3, M4 des Kontakts 3, 4 angelegt wird.

Grundsätzlich ist es vorgesehen, dass auf einer Oberseite der elektrisch isolierenden Schicht 14 der flexiblen Leiterplatte 10 die elektrisch leitende Oberschicht 15 ausgebildet ist, wobei diese den ersten Leiterbereich 19 und den zweiten Leiterbereich 20 umfasst. Der erste Leiterbereich 19 und der zweite Leiterbereich 20 sind jeweils als sich ringartig erstreckende, kupferkaschierte Fläche mit den ringförmig angeordneten Kontaktfahnen 19-1, 19-2 bzw. 20-1, 20-2, welche Kontaktlamellen bilden, ausgebildet.

Diese Flächen sind jeweils in einem inneren Kontaktbereich 19b bzw. 20b freigestellt, nämlich frei von einer Isolationsschicht. Diese Flächen sind jeweils in einem äußeren Kontaktbereich 19a bzw. 20a in einem ringförmigen Bereich, in welchem die Kontaktstifte KS3 bzw. KS4 mit ihrem Kragen K3 aufliegen freigestellt, nämlich frei von einer Isolationsschicht und außerhalb dieses ringförmigen Bereichs mit Lötstopplack oder Polyimidfolie abgedeckt. Diese Abdeckung der elektrisch leitenden Oberschicht in allen Bereichen, in welchen diese nicht mit den Kontaktstiften KS3 bzw. KS4 in Kontakt steht, dient dem Schutz und der Isolierung.

Die äußeren Kontaktbereiche 19a bzw. 20a der elektrisch leitenden Oberschicht 15 sind bezüglich ihrer Form derart ausgebildet, dass diese jeweils bis über den auf der elektrisch leitenden Unterschicht 16 liegenden Temperatursensor 17 bzw. 18 hinausragt, wobei der Temperatursensor 17 bzw. 18 jeweils auf einer Unterseite der elektrisch isolierenden Schicht 14 angeordnet ist.

Die elektrisch leitenden Unterschicht 17 der flexiblen Leiterplatte 10 umfasst dünne Leiterbahnen 26 bis 28 aus Kupfer und Pads bzw. Kontaktstellen 17a, 17b, 18a, 18b um die Temperatursensoren 17, 18 zu platzieren und thermisch möglichst entkoppelt anzubinden. Die Leiterbahnen 26 bis 28 sind ebenfalls zum Schutz mit Lötstopplack oder Polyimid abgedeckt. Zu den Ausnehmungen A14, B14 für die Kontaktstifte KS3, KS4 ist von der elektrisch leitenden Unterschicht 16 ein Mindestabstand eingehalten, welcher frei von Kupfer ist.

Oberhalb der flexiblen Leiterplatte 10 umfasst der Träger 2 die obere Deckplatte 9 mit kreisrund ausgeführten Durchgangsbohrungen A9, B9. Diese dienen jeweils der Zentrierung des Kontaktstiftes KS3 bzw. KS4 auf die Ausnehmungen A14, B14 der flexiblen Leiterplatte 10.

Unterhalb der flexiblen Leiterplatte 10 umfasst der Träger 2 wahlweise eine oder mehrere Platten - im Ausführungsbeispiel sind dies die Tragplatte 12 und die untere Deckplatte 11 - durch Kontakt mit dieser Platte oder diesen Platten 11, 12 werden die Kontaktfahnen 19-1, 19-2 bzw. 20-1, 20-2, auch als Lamellen bezeichnet - beim Zusammenbau der Elektroanschlusseinrichtung 1 im einem zweistufigen Biegeprozess aus ihrer in Bezug auf die Leiterplatte 10 horizontalen Ausrichtung an den ersten Kontaktstift KS3 und den zweiten Kontaktstift KS4 angeformt.

Nach der Montage wird insbesondere durch eine Verklebung der Weiterhin ist es vorgesehen, dass die Bauteile des Trägers 2 wenigstens teilweise miteinander verklebt sind. Somit ist sichergestellt, dass durch das komplette Assembly die erste Aufnahme 6 und die zweite Aufnahme 7 für die Kontaktstifte KS3 bzw. KS4 konzentrisch ausgebildet sind. Klebstoff kann weiterhin auch zur Reduktion von Kriechstrecken eingesetzt sein.

### Bezugszeichenliste:

- 1: Elektroanschlusseinrichtung
- 2: Träger
- 3: erster Kontakt
- 4: zweiter Kontakt
- 5: Regeleinrichtung
- 6: erste Aufnahme in 2 für 3
- 7: zweite Aufnahme in 2 für 4
- 9: obere Deckplatte von 2
- 10: Leiterplatte von 2
- 11: untere Deckplatte von 2
- 11a: Oberseite von 11
- 12: Tragplatte
- 12a: Oberseite von 12
- 14: elektrisch isolierende Schicht von 10
- 15: elektrisch leitende Oberschicht von 10
- 16: elektrisch leitende Unterschicht von 10
- 17: erster Temperatursensor
- 17a, 17b: Kontaktstelle auf 16 für 17
- 18: zweiter Temperatursensor
- 18a, 18b: Kontaktstelle auf 16 für 18
- 19: erster Leiterbereich von 15
- 19a: äußerer Anschlussbereich von 19
- 19b: innerer Kontaktbereich von 19
- 19-1, 19-2: Kontaktfahne von 19 bzw. 15 bzw. 10
- 20: zweiter Leiterbereich von 15
- 20a: äußerer Anschlussbereich von 20
- 20b: innerer Kontaktbereich von 20
- 20-1, 20-2: Kontaktfahne von 20 bzw. 15 bzw. 10
- 21, 22: Aussparung in 12 für 17, 18
- 23-25: Leitung zu 17, 18
- 26-28: Leiterbahn gebildet durch 16
- 29, 30: umlaufende Kante von 12 zu A12 bzw. B12
- 31, 32: 1. Biegekante gebildet durch 29 bzw. 30 an 12
- 33, 34: umlaufende Kanten um A11, B11 an 11a von 11
- 35, 36: 2. Biegekante gebildet durch 33, 34 an 11
- 37, 38: Innenmantelfläche von A11, B11
- 39, 40: Innkreis gebildet durch A11, B11

- A9, B9: Durchgangsbohrung in 9
- A11, B11: Durchgangsbohrung in 11
- A12, B12: erste, zweite polygonförmige Ausnehmung in 12
- A14, B14: erste, zweite Ausnehmung in 14
- K3,: Kragen von 3
- KU3: Unterseite von K3
- KS3, KS4: Kontaktstift gebildet durch 3, 4
- L3, L4: Längsachse von 3, 4
- LS: Ladestecker
- M3, M4: Mantelfläche von 3, 4
- S9-S12: Schlitz in 9, 10, 11, 12
- S19a, S20a: Segment von 19a, 20a
- x: Einschubrichtung

## Patentansprüche

1. Elektroanschlusseinrichtung (1) umfassend
- wenigstens einen Kontakt (3; 4) und einen Träger (2),
- eine Tragplatte (12)
- wobei der Träger (2) wenigstens eine Aufnahme (6; 7) umfasst und der Kontakt (3; 4) in diese Aufnahme (6; 7) eingesteckt ist,
- wobei der Träger (2) eine Leiterplatte (10) und wenigstens einen Temperatursensor (17; 18) umfasst,
- wobei der Temperatursensor (17; 18) auf der Leiterplatte (10) in der Nähe des Kontakts (3; 4) angeordnet ist,
- wobei die Leiterplatte (10) eine elektrisch isolierende Schicht (14) und eine von der Tragplatte (12) durch die elektrisch isolierende Schicht (14) getrennte, elektrisch leitende Oberschicht (15) umfasst,
- wobei die elektrisch leitende Oberschicht (15) im Bereich einer Ausnehmung (A14; B14) der elektrisch isolierenden Schicht (14) angeordnet ist und einen äußeren Anschlussbereich (19a; 20a) und einen inneren Kontaktbereich (19b; 20b) umfasst,
- wobei der innere Kontaktbereich (19b; 20b) durch den Kontakt (3; 4) derart durch eine Ausnehmung (A12; B12) der Tragplatte (12) hindurch umgeformt ist, dass die elektrisch leitende Oberschicht (15) an einer Mantelfläche (M3; M4) des Kontakts (3; 4) anliegt,
- wobei eine Oberseite (12a) der Tragplatte (12) angrenzend zu deren Ausnehmung (A12; B12) hin als primäre Biegekante (31; 32) ausgebildet ist, über welche die elektrisch leitende Oberschicht (15) der Leiterplatte (10) um 5° bis 90° umgebogen ist.

2. Elektroanschlusseinrichtung nach Anspruch 1, **dadurch gekennzeichnet, dass** die elektrisch leitende Oberschicht (15) um die Ausnehmung (A14; B14) der elektrisch isolierenden Schicht (14) herum mit der elektrisch isolierenden Schicht (14) verbunden ist.

3. Elektroanschlusseinrichtung nach wenigstens einem der vorhergehenden Ansprüche, **dadurch gekennzeichnet, dass** die Tragplatte (12) starr ausgebildet ist und dass die Leiterplatte (10) im Vergleich zu der Tragplatte (12) flexibel ausgebildet ist.

4. Elektroanschlusseinrichtung nach wenigstens einem der vorhergehenden Ansprüche, **dadurch gekennzeichnet, dass** die Leiterplatte (10) als dritte Schicht eine elektrisch leitende Unterschicht (16) umfasst, wobei die elektrisch leitende Unterschicht (16) von der elektrisch leitenden Oberschicht (15) durch die elektrisch isolierende Schicht (14) galvanisch getrennt ist, wobei der Temperatursensor (17; 18) auf der elektrisch leitenden Unterschicht (16) angeordnet ist und an durch die elektrisch leitende Unterschicht (16) ausgebildete Kontaktstellen (17a, 17b; 18a, 18b) angeschlossen ist, wobei der Temperatursensor (17; 18) derart positioniert ist, dass dieser einem Segment (S19a; S20a) der elektrisch leitenden Oberschicht (15) gegenüberliegt.

5. Elektroanschlusseinrichtung nach wenigstens einem der vorhergehenden Ansprüche, **dadurch gekennzeichnet, dass** die Tragplatte (12) wenigstens eine Aussparung (21; 22) umfasst, wobei die Aussparung (21; 22) zu der der Leiterplatte (10) zugewandten Oberseite (12a) der Tragplatte (12) geöffnet ist und dass die Aussparung (21, 22) derart positioniert und dimensioniert ist, dass der Temperatursensor (17; 18) in der Aussparung (21; 22) aufgenommen ist.

6. Elektroanschlusseinrichtung nach wenigstens einem der vorhergehenden Ansprüche, **dadurch gekennzeichnet,**
- **dass** die Kontaktstellen(17a, 17b; 18a, 18b), mit welchen der Temperatursensor (17; 18) verbunden ist, an Leitungen angeschlossen (23-25) sind,
- **dass** die Leitungen (23-25) in Form von Leiterbahnen (26-28) durch die elektrisch leitende Unterschicht (16) gebildet sind und zu dem Temperatursensor (17; 18) hin einen mäanderartigen Verlauf aufweisen und
- wobei es insbesondere vorgesehen ist, dass die Elektroanschlusseinrichtung (1) eine Regeleinrichtung (5) umfasst und dass der wenigstens eine Temperatursensor (17; 18) über die Leitungen an die Regeleinrichtung (5) angeschlossen ist.

7. Elektroanschlusseinrichtung nach wenigstens einem der vorhergehenden Ansprüche, **dadurch gekennzeichnet,**
- **dass** die Elektroanschlusseinrichtung (1) eine auf der Leiterplatte (10) aufliegende obere Deckplatte (9) umfasst und/oder
- **dass** die Elektroanschlusseinrichtung (12) eine auf der Tragplatte (12) aufliegende untere Deckplatte (11) umfasst.

8. Elektroanschlusseinrichtung nach wenigstens einem der vorhergehenden Ansprüche, **dadurch gekennzeichnet, dass** die Oberseite (12a) der Tragplatte (12) angrenzend zu deren Ausnehmung (A12; B12) hin als primäre Biegekante (31; 32) ausgebildet ist, über welche die elektrisch leitende Oberschicht (15) der Leiterplatte (10) um wenigstens 15° umgebogen ist.

9. Elektroanschlusseinrichtung nach wenigstens einem der vorhergehenden Ansprüche, **dadurch gekennzeichnet,**
- **dass** die Elektroanschlusseinrichtung (1) eine obere Deckplatte (9) umfasst, wobei die obere Deckplatte (9) eine auf die Ausnehmungen (A12, A14; B12, B14) der Leiterplatte (10) ausgerichtet obere Durchgangsbohrung (A9; B9) umfasst, wobei die obere Deckplatte (9) eine Oberseite der Leiterplatte (10) abdeckt und/oder
- **dass** die Elektroanschlusseinrichtung (1) eine untere Deckplatte (11) umfasst, wobei die untere Deckplatte (11) eine auf die Ausnehmungen (A12, A14; B12, B14) der Leiterplatte (10) ausgerichtet untere Durchgangsbohrung (A9; B9) umfasst, wobei die untere Deckplatte (9) eine Unterseite der Tragplatte (12) abdeckt.

10. Elektroanschlusseinrichtung nach Anspruch 9, **dadurch gekennzeichnet, dass** eine umlaufende Kante (33, 34) der unteren Deckplatte (11), an welcher eine Oberseite der unteren Deckplatte (11) in eine untere Durchgangsbohrung (A11; B11) übergeht, eine sekundäre Biegekante (35; 36) bildet, durch welche die elektrisch leitende Oberschicht (15) der Leiterplatte (10) an die Mantelfläche (M3; M4) des Kontakts (3; 4) derart angeformt ist, dass die elektrisch leitende Oberschicht (15) zwischen einer Innenmantelfläche (37; 38) der unteren Durchgangsbohrung (A11; B11) und der Mantelfläche (M3; M4) des Kontakts (3; 4) eingeklemmt ist.

11. Elektroanschlusseinrichtung nach wenigstens einem der vorhergehenden Ansprüche, **dadurch gekennzeichnet, dass** die Elektronanschlusseinrichtung (1) die zwei Kontakte (3; 4) und den Träger (2) umfasst, wobei der Träger (2) die Tragplatte (12) und die Leiterplatte (10) und insbesondere die obere Deckplatte (9) und insbesondere die untere Deckplatte (11) umfasst, wobei diese Platten miteinander verbunden sind und jeweils einen zwischen den Kontakten (3; 4) angeordneten Schlitz (S9; S10; S11; S12) umfassen, wobei die Kontakte (3; 4) spiegelbildlich zu den Schlitzen (S9; S10; S11; S12) angeordnet sind.

12. Elektroanschlusseinrichtung nach wenigstens einem der vorhergehenden Ansprüche, **dadurch gekennzeichnet, dass** die Ausnehmung (A12; B12) in der Tragplatte (12) als polygonförmige Ausnehmung ausgebildet ist und dass die untere Durchgangsbohrung (A11; B11) in der unteren Deckplatte (11) kreisförmig ausgebildet ist und wobei es insbesondere vorgesehen ist, dass die untere Durchgangsbohrung (A11; B11) in einer Projektion in Richtung einer Längsachse (L3; L4) des Kontakts (3; 4) einen Inkreis (39, 40) der polygonförmigen Ausnehmung bildet.

13. Elektroanschlusseinrichtung nach wenigstens einem der vorhergehenden Ansprüche, **dadurch gekennzeichnet, dass** der äußere Anschlussbereich (19a; 20a) des Leiterbereichs (19; 20) der elektrisch leitenden Oberschicht (15) die Ausnehmung (A14; B14) der Leiterplatte (10) ringartig umgibt und dass der innere Kontaktbereich (19b; 20b) der elektrisch leitenden Oberschicht (15) durch von dem äußeren Anschlussbereich (19a; 20a) ausgehende Kontaktfahnen (19-1, 19-2; 20-1, 20-2) gebildet ist, wobei es insbesondere vorgesehen ist, dass die Zahl der Kontaktfahnen (19-1, 19-2; 20-1, 20-2) der Zahl der Ecken der polygonförmige Ausnehmung (A12; B12) der Tragplatte (12) entspricht.

14. Elektroanschlusseinrichtung nach wenigstens einem der vorhergehenden Ansprüche, **dadurch gekennzeichnet, dass** der Kontakt (3; 4) einen über seine Mantelfläche (M3; M4) vorspringenden, umlaufenden Kragen (K3) umfasst und mit einer kreisringförmigen Unterseite (KU3) seines Kragens (K3) auf dem äußeren Anschlussbereich (19a; 20a) der elektrisch leitenden Oberschicht (15) der Leiterplatte (10) anliegt.

15. Elektroanschlusseinrichtung nach wenigstens einem der vorhergehenden Ansprüche, **dadurch gekennzeichnet,**
- **dass** die Elektroanschlusseinrichtung (1) als Ladestecker (LS) ausgebildet ist und der wenigstens eine Kontakt (3; 4) jeweils als Kontaktstift (KS3; KS4) ausgebildet ist oder
- **dass** die Elektroanschlusseinrichtung (1) als Ladebuchse ausgebildet ist und der wenigstens eine Kontakt jeweils als Kontakthülse ausgebildet ist.

16. Verfahren zur Montage einer Elektroanschlusseinrichtung (1) entsprechend wenigstens einem der Ansprüche 1 bis 15,
- wobei die Elektroanschlusseinrichtung (1) einen Träger (2) mit wenigstens einer Aufnahme (6; 7) und wenigstens einen Kontakt (3; 4) umfasst,
- wobei der Träger (2) in eine Einschubrichtung (x) des Kontakts (3; 4) betrachtet eine Leiterplatte (10) mit einer elektrisch leitenden Oberschicht (15), eine insbesondere polygonförmig umlaufende primäre Biegekante (31; 32) und eine insbesondere kreisförmig umlaufende sekundäre Biegekante (35; 36) umfasst,
- wobei die elektrisch leitende Oberschicht (15) insbesondere mit Kontaktfahnen (19-1, 19-2; 20-1, 20-2) in die Aufnahme (6; 7) ragt,
wobei das Verfahren die nachfolgenden Schritte umfasst:
- Einschieben des Kontakts (3; 4) bis von dem Kontakt (3; 4) die in die Aufnahme (6; 7) ragende elektrisch leitende Oberschicht (15) berührt wird,
- weiteres Einschieben des Kontakts (3; 4) in die Aufnahme (6; 7) und hierbei Umbiegen der elektrisch leitenden Oberschicht (15) und insbesondere auch der elektrisch isolierenden Schicht (14) durch den Kontakt (3; 4) an der primären Biegekante (31; 32) und
- noch weiteres Einschieben des Kontakts (3; 4) in die Aufnahme (6; 7) und hierbei Umbiegen der elektrisch leitenden Oberschicht (15) und auch der elektrisch isolierenden Schicht (14) durch den Kontakt (3; 4) an der sekundären Biegekante (35; 36) und Anlagen der Kontaktfahnen (19-1, 19-2; 20-1, 20-2) an eine Mantelfläche (M3; M4) des Kontakts (3; 4) derart, dass die elektrische leitende Oberschicht (15) in einem der sekundären Biegekante (35; 36) folgenden Bereich vollflächig an der Mantelfläche (M3; M4) des Kontakts (3; 4) angelegt wird.

## Claims

1. Electrical connection device (1) comprising
- at least one contact (3; 4) and a carrier (2),
- a support plate (12),
- wherein the carrier (2) comprises at least one receptacle (6; 7) and the contact (3; 4) is inserted into this receptacle (6; 7),
- wherein the carrier (2) comprises a printed circuit board (10) and at least one temperature sensor (17; 18),
- wherein the temperature sensor (17; 18) is arranged on the printed circuit board (10) in the vicinity of the contact (3; 4),
- wherein the printed circuit board (10) comprises an electrically insulating layer (14) and an electrically conductive top layer (15) separated from the support plate (12) by the electrically insulating layer (14),
- wherein the electrically conductive top layer (15) is arranged in the region of a recess (A14; B14) of the electrically insulating layer (14) and comprises an outer connection region (19a; 20a) and an inner contact region (19b; 20b),
- wherein the inner contact region (19b; 20b) is formed by the contact (3; 4) through a recess (A12; B12) of the support plate (12) in such a way that the electrically conductive top layer (15) rests against a lateral surface (M3; M4) of the contact (3; 4),
- wherein a top side (12a) of the support plate (12) adjacent to the recess (A12; B12) thereof is formed as a primary bending edge (31; 32) over which the electrically conductive top layer (15) of the printed circuit board (10) is bent by 5° to 90°.

2. Electrical connection device according to Claim 1, **characterized in that** the electrically conductive top layer (15) is connected to the electrically insulating layer (14) around the recess (A14; B14) of the electrically insulating layer (14).

3. Electrical connection device according to at least one of the preceding claims, **characterized in that** the support plate (12) is rigid, and **in that** the printed circuit board (10) is flexible compared to the support plate (12).

4. Electrical connection device according to at least one of the preceding claims, **characterized in that** the printed circuit board (10) comprises an electrically conductive bottom layer (16) as a third layer, wherein the electrically conductive bottom layer (16) is galvanically isolated from the electrically conductive top layer (15) by the electrically insulating layer (14), wherein the temperature sensor (17; 18) is arranged on the electrically conductive bottom layer (16) and is connected to contact points (17a, 17b; 18a, 18b) formed by the electrically conductive bottom layer (16), wherein the temperature sensor (17; 18) is positioned in such a way that it faces a segment (S19a; S20a) of the electrically conductive top layer (15).

5. Electrical connection device according to at least one of the preceding claims, **characterized in that** the support plate (12) comprises at least one recess (21; 22), wherein the recess (21; 22) is open towards the top side (12a) of the support plate (12) facing the printed circuit board (10), and **in that** the recess (21, 22) is positioned and dimensioned in such a way that the temperature sensor (17; 18) is received in the recess (21; 22).

6. Electrical connection device according to at least one of the preceding claims, **characterized**
- **in that** the contact points (17a, 17b; 18a, 18b) to which the temperature sensor (17; 18) is connected are attached to lines (23-25),
- **in that** the lines (23-25) in the form of conductor tracks (26-28) are formed by the electrically conductive bottom layer (16) and have a meandering course towards the temperature sensor (17; 18), and
- wherein it is particularly provided that the electrical connection device (1) comprises a control device (5), and that the at least one temperature sensor (17; 18) is attached to the control device (5) via the lines.

7. Electrical connection device according to at least one of the preceding claims, **characterized**
- **in that** the electrical connection device (1) comprises an upper cover plate (9) resting on the printed circuit board (10), and/or
- **in that** the electrical connection device (12) comprises a lower cover plate (11) resting on the support plate (12).

8. Electrical connection device according to at least one of the preceding claims, **characterized in that** the top side (12a) of the support plate (12) adjacent to the recess (A12; B12) thereof is formed as a primary bending edge (31; 32) over which the electrically conductive top layer (15) of the printed circuit board (10) is bent by at least 15°.

9. Electrical connection device according to at least one of the preceding claims, **characterized**
- **in that** the electrical connection device (1) comprises an upper cover plate (9), wherein the upper cover plate (9) comprises an upper through-bore (A9; B9) aligned with the recesses (A12, A14; B12, B14) of the printed circuit board (10), wherein the upper cover plate (9) covers a top side of the printed circuit board (10), and/or
- **in that** the electrical connection device (1) comprises a lower cover plate (11), wherein the lower cover plate (11) comprises a lower through-bore (A9; B9) aligned with the recesses (A12, A14; B12, B14) of the printed circuit board (10), wherein the lower cover plate (9) covers a bottom side of the support plate (12).

10. Electrical connection device according to Claim 9, **characterized in that** a circumferential edge (33, 34) of the lower cover plate (11), at which a top side of the lower cover plate (11) transitions into a lower through-bore (A11; B11), forms a secondary bending edge (35; 36), by which the electrically conductive top layer (15) of the printed circuit board (10) is moulded against the lateral surface (M3; M4) of the contact (3; 4) in such a way that the electrically conductive top layer (15) is clamped between an inner lateral surface (37; 38) of the lower through-bore (A11; B11) and the lateral surface (M3; M4) of the contact (3; 4).

11. Electrical connection device according to at least one of the preceding claims, **characterized in that** the electrical connection device (1) comprises the two contacts (3; 4) and the carrier (2), wherein the carrier (2) comprises the support plate (12) and the printed circuit board (10) and, in particular, the upper cover plate (9) and, in particular, the lower cover plate (11), wherein these plates are connected to one another and each comprise a slot (S9; S10; S11; S12) arranged between the contacts (3; 4), wherein the contacts (3; 4) are arranged in a mirror image with respect to the slots (S9; S10; S11; S12).

12. Electrical connection device according to at least one of the preceding claims, **characterized in that** the recess (A12; B12) in the support plate (12) is formed as a polygonal recess, and **in that** the lower through-bore (A11; B11) in the lower cover plate (11) is circular, and wherein it is provided in particular that the lower through-bore (A11; B11) forms an incircle (39, 40) of the polygonal recess in a projection in the direction of a longitudinal axis (L3; L4) of the contact (3; 4).

13. Electrical connection device according to at least one of the preceding claims, **characterized in that** the outer connection region (19a; 20a) of the conductor region (19; 20) of the electrically conductive top layer (15) surrounds the recess (A14; B14) of the printed circuit board (10) in a ring-like manner, and **in that** the inner contact region (19b; 20b) of the electrically conductive top layer (15) is formed by contact lugs (19-1, 19-2; 20-1, 20-2) extending from the outer connection region (19a; 20a), wherein it is provided in particular that the number of contact lugs (19-1, 19-2; 20-1, 20-2) corresponds to the number of corners of the polygonal recess (A12; B12) of the support plate (12).

14. Electrical connection device according to at least one of the preceding claims, **characterized in that** the contact (3; 4) comprises a circumferential collar (K3) projecting beyond its lateral surface (M3; M4) and rests with a circular-ring-shaped bottom side (KU3) of its collar (K3) on the outer connection region (19a; 20a) of the electrically conductive top layer (15) of the printed circuit board (10).

15. Electrical connection device according to at least one of the preceding claims, **characterized**
- **in that** the electrical connection device (1) is formed as a charging plug (LS) and the at least one contact (3; 4) is formed in each case as a contact pin (KS3; KS4), or
- **in that** the electrical connection device (1) is formed as a charging socket and the at least one contact is formed in each case as a contact sleeve.

16. Method for assembling an electrical connection device (1) in accordance with at least one of Claims 1 to 15,
- wherein the electrical connection device (1) comprises a carrier (2) with at least one receptacle (6; 7) and at least one contact (3; 4),
- wherein the carrier (2), viewed in a direction of insertion (x) of the contact (3; 4), comprises a printed circuit board (10) with an electrically conductive top layer (15), a primary bending edge (31; 32), running circumferentially in particular in a polygonal shape, and a secondary bending edge (35; 36), running circumferentially in particular in a circular shape,
- wherein the electrically conductive top layer (15) projects into the receptacle (6; 7), in particular with contact lugs (19-1, 19-2; 20-1, 20-2),
wherein the method comprises the following steps:
- inserting the contact (3; 4) until the contact (3; 4) touches the electrically conductive top layer (15) projecting into the receptacle (6; 7),
- inserting the contact (3; 4) further into the receptacle (6; 7) and thereby bending the electrically conductive top layer (15) and in particular also the electrically insulating layer (14) by the contact (3; 4) at the primary bending edge (31; 32) and
- inserting the contact (3; 4) further still into the receptacle (6; 7) and thereby bending the electrically conductive top layer (15) and also the electrically insulating layer (14) by the contact (3; 4) at the secondary bending edge (35; 36) and applying the contact lugs (19-1, 19-2; 20-1, 20-2) against a lateral surface (M3; M4) of the contact (3; 4) in such a way that the electrically conductive top layer (15) is applied over its entire surface against the lateral surface (M3; M4) of the contact (3; 4) in a region following the secondary bending edge (35; 36).

## Revendications

1. Dispositif de raccordement électrique (1) comprenant
- au moins un contact (3 ; 4) et un support (2),
- une plaque porteuse (12)
- le support (2) comportant au moins un logement (6 ; 7) et le contact (3 ; 4) étant enfiché dans ce logement (6 ; 7),
- le support (2) comportant une carte à circuit imprimé (10) et au moins un capteur de température (17 ; 18),
- le capteur de température (17 ; 18) étant disposé sur la carte à circuit imprimé (10) à proximité du contact (3 ; 4),
- la carte à circuit imprimé (10) comportant une couche électriquement isolante (14) et une couche supérieure électriquement conductrice (15) séparée de la plaque porteuse (12) par la couche électriquement isolante (14),
- la couche supérieure électriquement conductrice (15) étant disposée dans la zone d'un évidement (A14 ; B14) de la couche électriquement isolante (14) et comportant une zone de raccordement extérieure (19a ; 20a) et une zone de contact intérieure (19b ; 20b),
- la zone de contact intérieure (19b ; 20b) étant déformée par le contact (3 ; 4) à travers un évidement (A12 ; B12) de la plaque porteuse (12) de telle sorte que la couche supérieure électriquement conductrice (15) repose contre une surface d'enveloppe (M3 ; M4) du contact (3 ; 4),
- un côté supérieur (12a) de la plaque porteuse (12) adjacent à son évidement (A12 ; B12) étant réalisé sous la forme d'un bord de pliage primaire (31 ; 32), par le biais duquel la couche supérieure électriquement conductrice (15) de la carte à circuit imprimé (10) est pliée de 5° à 90°.

2. Dispositif de raccordement électrique selon la revendication 1, **caractérisé en ce que** la couche supérieure électriquement conductrice (15) est connectée à la couche électriquement isolante (14) autour de l'évidement (A14 ; B14) de la couche électriquement isolante (14).

3. Dispositif de raccordement électrique selon au moins l'une des revendications précédentes, **caractérisé en ce que** la plaque porteuse (12) est de configuration rigide et **en ce que** la carte à circuit imprimé (10) est flexible par rapport à la plaque porteuse (12).

4. Dispositif de raccordement électrique selon au moins l'une des revendications précédentes, **caractérisé en ce que** la carte à circuit imprimé (10) comporte, en tant que troisième couche, une couche inférieure électriquement conductrice (16), la couche inférieure électriquement conductrice (16) étant séparée galvaniquement de la couche supérieure électriquement conductrice (15) par la couche électriquement isolante (14), le capteur de température (17 ; 18) étant disposé sur la couche inférieure électriquement conductrice (16) et étant raccordé à des points de contact (17a, 17b ; 18a, 18b) formés par la couche inférieure électriquement conductrice (16), le capteur de température (17 ; 18) étant positionné de telle sorte que celui-ci se trouve en face d'un segment (S19a ; S20a) de la couche supérieure électriquement conductrice (15).

5. Dispositif de raccordement électrique selon au moins l'une des revendications précédentes, **caractérisé en ce que** la plaque porteuse (12) comporte au moins un évidement (21 ; 22), l'évidement (21 ; 22) étant ouvert vers le côté supérieur (12a) de la plaque porteuse (12) qui fait face à la carte à circuit imprimé (10), et **en ce que** l'évidement (21, 22) est positionné et dimensionné de telle sorte que le capteur de température (17 ; 18) est logé dans l'évidement (21 ; 22).

6. Dispositif de raccordement électrique selon au moins l'une des revendications précédentes, **caractérisé**
- **en ce que** les points de contact (17a, 17b ; 18a, 18b) auxquels est connecté le capteur de température (17 ; 18) sont raccordés à des lignes (23-25),
- **en ce que** les lignes (23-25) sont réalisées sous la forme de pistes conductrices (26-28) à travers la couche inférieure électriquement conductrice (16) et présentent un tracé en méandres en direction du capteur de température (17 ; 18), et
- en étant notamment prévu que le dispositif de raccordement électrique (1) comporte un dispositif de régulation (5) et en ce que l'au moins un capteur de température (17 ; 18) est raccordé au dispositif de régulation (5) par le biais des lignes.

7. Dispositif de raccordement électrique selon au moins l'une des revendications précédentes, **caractérisé**
- **en ce que** le dispositif de raccordement électrique (1) comporte une plaque de recouvrement supérieure (9) qui repose sur la carte à circuit imprimé (10) et/ou
- **en ce que** le dispositif de raccordement électrique (12) comporte une plaque de recouvrement inférieure (11) qui repose sur la plaque porteuse (12).

8. Dispositif de raccordement électrique selon au moins l'une des revendications précédentes, **caractérisé en ce que** le côté supérieur (12a) de la plaque porteuse (12) adjacent à son évidement (A12 ; B12) est réalisé sous la forme d'un bord de pliage primaire (31 ; 32), par le biais duquel la couche supérieure électriquement conductrice (15) de la carte à circuit imprimé (10) est pliée de 15°.

9. Dispositif de raccordement électrique selon au moins l'une des revendications précédentes, **caractérisé**
- **en ce que** le dispositif de raccordement électrique (1) comporte une plaque de recouvrement supérieure (9), la plaque de recouvrement supérieure (9) comprenant un trou traversant supérieur (A9 ; B9) orienté sur les évidements (A12, A14 ; B12, B14) de la carte à circuit imprimé (10), la plaque de recouvrement supérieure (9) recouvrant un côté supérieur de la carte à circuit imprimé (10) et/ou
- **en ce que** le dispositif de raccordement électrique (1) comporte une plaque de recouvrement inférieure (11), la plaque de recouvrement inférieure (11) comprenant un trou traversant inférieur (A9 ; B9) orienté sur les évidements (A12, A14 ; B12, B14) de la carte à circuit imprimé (10), la plaque de recouvrement inférieure (9) recouvrant un côté inférieur de la plaque porteuse (12).

10. Dispositif de raccordement électrique selon la revendication 9, **caractérisé en ce qu'**un bord périphérique (33, 34) de la plaque de recouvrement inférieure (11), au niveau duquel un côté supérieur de la plaque de recouvrement inférieure (11) devient un trou traversant inférieur (A11 ; B11), forme un bord de pliage secondaire (35 ; 36) par lequel la couche supérieure électriquement conductrice (15) de la carte à circuit imprimé (10) est façonnée contre la surface d'enveloppe (M3 ; M4) du contact (3 ; 4) de telle sorte que la couche supérieure électriquement conductrice (15) est coincée entre une surface d'enveloppe intérieure (37 ; 38) du trou traversant inférieur (A11 ; B11) et la surface d'enveloppe (M3 ; M4) du contact (3 ; 4).

11. Dispositif de raccordement électronique selon au moins l'une des revendications précédentes, **caractérisé en ce que** le dispositif de raccordement électronique (1) comporte les deux contacts (3 ; 4) et le support (2), le support (2) comportant la plaque porteuse (12) et la carte à circuit imprimé (10) et notamment la plaque de recouvrement supérieure (9) et notamment la plaque de recouvrement inférieure (11), ces plaques étant reliées entre elles et comportant chacune une fente (S9 ; S10 ; S11 ; S12) disposée entre les contacts (3 ; 4), les contacts (3 ; 4) étant disposés en miroir par rapport aux fentes (S9 ; S10 ; S11 ; S12).

12. Dispositif de raccordement électrique selon au moins l'une des revendications précédentes, **caractérisé en ce que** l'évidement (A12 ; B12) dans la plaque porteuse (12) est réalisé sous la forme d'un évidement polygonal et **en ce que** le trou traversant inférieur (A11 ; B11) dans la plaque de recouvrement inférieure (11) est réalisé de forme circulaire, et en étant notamment prévu que le trou traversant inférieur (A11 ; B11) forme, dans une projection dans la direction d'un axe longitudinal (L3 ; L4) du contact (3 ; 4), un cercle inscrit (39, 40) de l'évidement polygonal.

13. Dispositif de raccordement électrique selon au moins l'une des revendications précédentes, **caractérisé en ce que** la zone de raccordement extérieure (19a ; 20a) de la zone conductrice (19 ; 20) de la couche supérieure électriquement conductrice (15) entoure l'évidement (A14 ; B14) de la carte à circuit imprimé (10) à la manière d'un anneau et **en ce que** la zone de contact intérieure (19b ; 20b) de la couche supérieure électriquement conductrice (15) est formée par des languettes de contact (19-1, 19-2 ; 20-1, 20-2) partant de la zone de raccordement extérieure (19a ; 20a), en étant notamment prévu que le nombre de languettes de contact (19-1, 19-2 ; 20-1, 20-2) correspond au nombre de coins de l'évidement polygonal (A12 ; B12) de la plaque porteuse (12).

14. Dispositif de raccordement électrique selon au moins l'une des revendications précédentes, **caractérisé en ce que** le contact (3 ; 4) comprend une collerette périphérique (K3) qui fait saillie sur sa surface d'enveloppe (M3 ; M4) et repose, par un côté inférieur de forme annulaire (KU3) de sa collerette (K3), sur la zone de raccordement extérieure (19a ; 20a) de la couche supérieure électriquement conductrice (15) de la carte à circuit imprimé (10).

15. Dispositif de raccordement électrique selon au moins l'une des revendications précédentes, **caractérisé**
- **en ce que** le dispositif de raccordement électrique (1) est réalisé sous la forme d'une fiche de charge (LS) et l'au moins un contact (3 ; 4) est réalisé respectivement sous la forme d'une broche de contact (KS3 ; KS4) ou
- **en ce que** le dispositif de raccordement électrique (1) est réalisé sous la forme d'une prise de charge et l'au moins un contact est réalisé respectivement sous la forme d'une douille de contact.

16. Procédé de montage d'un dispositif de raccordement électrique (1) selon au moins l'une des revendications 1 à 15,
- le dispositif de raccordement électrique (1) comportant un support (2) pourvu d'au moins un logement (6 ; 7) et d'au moins un contact (3 ; 4),
- le support (2), vu dans une direction d'insertion (x) du contact (3 ; 4), comportant une carte à circuit imprimé (10) ayant une couche supérieure électriquement conductrice (15), un bord de pliage primaire (31 ; 32) qui suit un tracé périphérique notamment polygonal et un bord de pliage secondaire (35 ; 36) qui suit un tracé périphérique notamment circulaire,
- la couche supérieure électriquement conductrice (15) faisant saillie dans le logement (6 ; 7), notamment avec des languettes de contact (19-1, 19-2 ; 20-1, 20-2),
le procédé comprenant les étapes suivantes :
- insertion du contact (3 ; 4) jusqu'à ce que le contact (3 ; 4) touche la couche supérieure électriquement conductrice (15) qui fait saillie dans le logement (6 ; 7),
- poursuite de l'insertion du contact (3 ; 4) dans le logement (6 ; 7) et ainsi pliage de la couche supérieure électriquement conductrice (15) et notamment aussi de la couche électriquement isolante (14) par le contact (3 ; 4) au niveau du bord de pliage primaire (31 ; 32) et
- encore poursuite de l'insertion du contact (3 ; 4) dans le logement (6 ; 7) et ainsi pliage de la couche supérieure électriquement conductrice (15) et aussi de la couche électriquement isolante (14) par le contact (3 ; 4) au niveau du bord de pliage secondaire (35 ; 36) et application des languettes de contact (19-1, 19-2 ; 20-1, 20-2) contre une surface d'enveloppe (M3 ; M4) du contact (3 ; 4) de telle sorte que la couche supérieure électriquement conductrice (15) repose sur toute sa surface contre la surface d'enveloppe (M3 ; M4) du contact (3 ; 4) dans une zone qui suit le bord de pliage secondaire (35 ; 36).
